# FASCICULE DE BREVET EUROPEEN

(11) **EP 2 747 277 B1**
(45) Date de publication et mention de la délivrance du brevet: **12.02.2020**
(21) Numéro de dépôt: 13193127.1
(22) Date de dépôt: 15.11.2013
(51) Int. Cl.: G01R 22/10, H04B 3/54, H03D 1/10, H04L 27/06, H04L 27/08

(54) **Dispositif de démodulation**
Demodulationsvorrichtung
Demodulation device

(30) Priorité: 18.12.2012 FR 1262268
(43) Date de publication de la demande: 25.06.2014
(73) Titulaire: Sagemcom Energy & Telecom SAS, 92500 Rueil-Malmaison (FR)
(72) Inventeur: Gaudin, Jean-Michel, 92500 Rueil Malmaison (FR)
(74) Mandataire: Lavialle, Bruno François Stéphane

(56) Documents cités:
- CA-A1- 2 260 486
- US-A- 3 467 913
- US-A- 3 736 520
- US-A- 3 828 263
- US-A- 4 301 445
- US-A- 4 602 381
- US-A- 5 218 318
- US-A- 5 737 033
- US-A1- 2009 052 586
- US-A1- 2010 189 196
- US-B1- 7 390 960

## Description

L'invention concerne un dispositif de démodulation adapté à démoduler un signal de télé-information client émis par un compteur d'énergie électrique.

### ARRIERE PLAN DE L'INVENTION

La plupart des compteurs d'énergie électrique récents sont munis d'une interface normalisée appelée interface « télé-information client » (TIC), grâce à laquelle un utilisateur du compteur peut recevoir un certain nombre d'informations TIC à propos de la consommation électrique de l'installation raccordée au compteur, parmi lesquelles le niveau de consommation, l'option tarifaire choisie, l'intensité souscrite, la période tarifaire en cours, etc. Pour accéder à ces informations TIC via l'interface TIC, l'utilisateur doit connecter un équipement particulier adapté à recevoir un signal émis par le compteur contenant les informations TIC. Cet équipement, appelé dans la suite de ce document « module communiquant », peut être dédié à cette fonction d'acquisition des informations TIC, ou bien peut être adapté à réaliser des fonctions différentes, comme la gestion de la consommation, le délestage, etc.

La norme EN 62056-32, qui normalise les échanges de données pour la lecture des compteurs, définit certaines caractéristiques du protocole de communication utilisé et prévoit notamment : une transmission unidirectionnelle d'une suite de caractères ASCII (pour « American Standard Code for Information Interchange », que l'on traduit généralement par « Code américain normalisé pour l'échange d'information »), une modulation d'amplitude sur une fréquence porteuse de 50 kHz, une fréquence de modulation de 9600 bits/s, etc. Une logique de codage négative est employée : une absence de porteuse dans le signal de réception est interprétée comme signifiant l'émission d'un état « zéro », alors qu'une présence de porteuse est interprétée comme un état « un ». On note que la fréquence de modulation utilisée est très proche de la fréquence porteuse : un état « zéro » correspond à seulement cinq périodes du signal porteur. Ceci rend la démodulation du signal particulièrement sensible à des déformations du signal pouvant être causées par des perturbations résultant par exemple de la présence de composants de protection du compteur électrique et du module communiquant (transformateur, capacités, etc.).

Les documents US 3 828 263 A, CA 2 260 486 A1 et US 4 602 381 A décrivent des dispositifs de démodulation de l'art antérieur.

### OBJET DE L'INVENTION

L'invention a pour objet de fournir un dispositif de démodulation adapté à démoduler de manière fiable et robuste un signal conforme à la norme EN 62056-32, émis par un compteur d'énergie électrique.

### RESUME DE L'INVENTION

En vue de la réalisation de ce but, on propose un dispositif de démodulation adapté à reproduire un signal numérique à partir d'un signal modulé alternatif reçu par le dispositif de démodulation, le signal modulé étant issu de la superposition du signal numérique et d'une porteuse, le dispositif de démodulation comportant :
- un étage à gain variable adapté à ajuster l'amplitude du signal modulé alternatif reçu en la multipliant par un gain pouvant prendre au moins deux valeurs différentes, de manière à délivrer un signal ajusté ;
- un étage redresseur double alternance sans seuil, comportant des diodes, et adapté à redresser des alternances négatives du signal ajusté tout en minimisant l'influence de tensions de seuil des diodes, de manière à fournir un signal redressé ;
- un étage de détection d'enveloppe adapté à détecter l'enveloppe du signal redressé, de manière à délivrer un signal d'enveloppe, l'étage de détection d'enveloppe comprenant une diode Schottky, une résistance et un condensateur ;
- un comparateur à hystérésis adapté à comparer le signal d'enveloppe avec un seuil de comparaison, de manière à restituer le signal numérique.

L'étage à gain variable peut être agencé en vue d'obtenir un signal ajusté ayant une amplitude optimisant le fonctionnement des autres étages. L'étage redresseur permet quant à lui de générer un signal dont l'amplitude varie sur une plage relativement faible. L'étage de détection d'enveloppe génère donc un signal ayant une amplitude sensiblement constante pendant toute la durée d'un état « zéro », ce qui rend la comparaison effectuée par le comparateur à hystérésis plus fiable. On obtient donc un dispositif de démodulation robuste aux déformations du signal modulé reçu.

L'invention sera mieux comprise à la lumière de la description qui suit d'un mode de mise en œuvre particulier non limitatif de l'invention.

### BREVE DESCRIPTION DES DESSINS

Il sera fait référence aux dessins annexés, parmi lesquels :
- la figure 1 représente schématiquement un compteur d'énergie électrique connecté à un module communiquant dans lequel est intégré le dispositif de démodulation de l'invention ;
- la figure 2 représente des moyens de connexion du module communiquant au compteur selon un premier mode de réalisation ;
- la figure 3 représente des moyens de connexion du module communiquant au compteur selon un deuxième mode de réalisation ;
- la figure 4 représente le dispositif de démodulation de l'invention selon un premier mode de réalisation ;

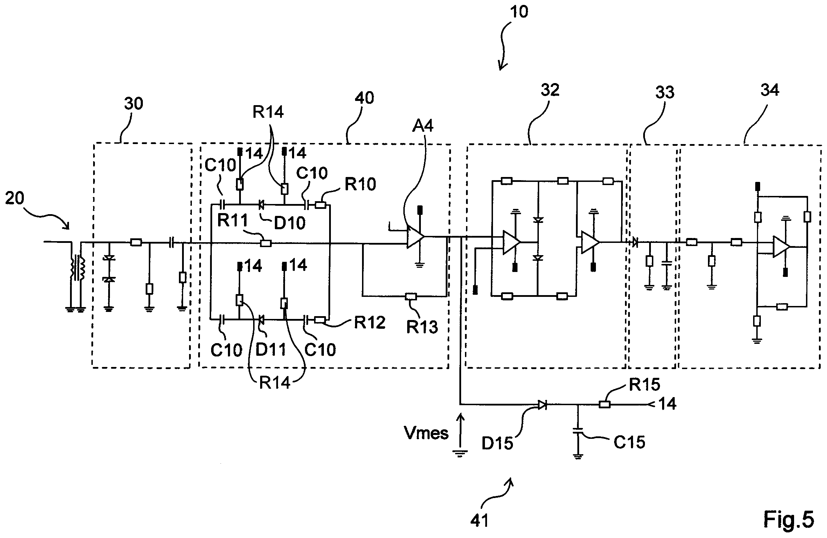

- la figure 5 représente le dispositif de démodulation de l'invention selon un deuxième mode de réalisation.

### DESCRIPTION DETAILLEE DE L'INVENTION

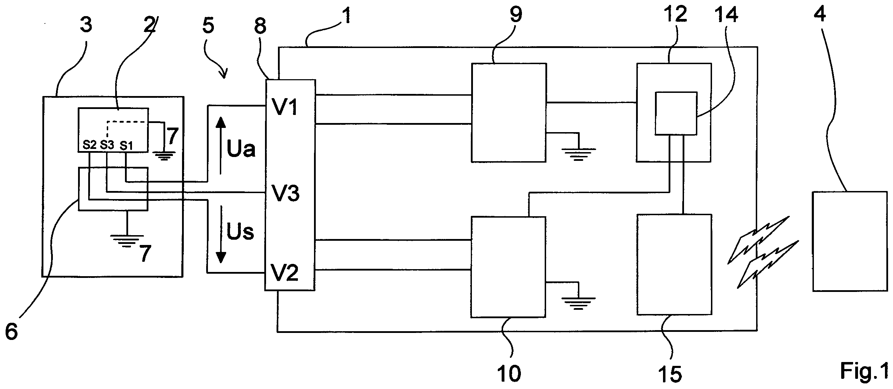

En référence à la figure 1, l'invention concerne un équipement électrique 1 appelé ici « module communiquant », destiné à recevoir des informations de consommation électrique provenant d'une interface TIC 2 mise en œuvre dans un compteur d'énergie électrique 3. Le module communiquant est en outre adapté à mettre en forme ces information TIC, et à les réémettre par transmission radioélectrique vers un module passerelle 4 dont le rôle est notamment de lire et de mémoriser les informations TIC émises par un certain nombre de compteurs d'énergie électrique semblables au compteur 3.

Le module communiquant 1 est relié à l'interface TIC du compteur par une liaison filaire 5, ici un bus à trois fils, via un bornier électrique 6 monté sur le compteur. L'interface TIC, définie par la norme EN 62056-32, comporte trois sorties reliées à trois voies du bornier : une sortie d'alimentation S1, une sortie de signal S2, et une sortie de masse S3, connectée à une masse électrique 7 du compteur 3. Le module communiquant 1 est muni de moyens de connexion 8 qui coopèrent avec le bornier 6 et qui comportent trois voies d'entrée, une voie d'alimentation V1, une voie de signal V2, et une voie de masse V3, connectées respectivement, via les voies du bornier, à la sortie d'alimentation S1 , à la sortie de signal S2 et à la sortie de masse S3 de l'interface TIC 2.

Le compteur 3 transmet au module communiquant 1 un signal de données via la sortie signal S2. Le signal de données est ici un signal modulé alternatif, issu de la superposition d'un signal numérique constitué d'une suite de caractères en ASCII contenant les informations TIC, et d'une fréquence porteuse f0 à 50 kHz. Une logique de codage négative est employée. La fréquence de modulation fM est de 9600 bits/secondes, ce qui signifie qu'un état « zéro » correspond à cinq périodes de la porteuse f0. Le signal de données résulte d'une différence de potentiel Us entre la sortie de signal S2 et la sortie de masse S3.

Le compteur 3 transmet en outre au module communiquant 1 une tension d'alimentation alternative Ua via la sortie d'alimentation. Ce signal est destiné à alimenter le module communiquant 1, et est constitué par la porteuse f0 émise en continu. La tension d'alimentation Ua résulte d'une différence de potentiel entre la sortie d'alimentation S1 et la sortie de masse S3.

Le module communiquant 1 comporte donc :
- les moyens de connexion 8 adaptés à connecter le module communiquant 1 au compteur 3 via le bornier 6;
- un module d'alimentation 9 relié électriquement à la voie d'alimentation V1 adapté à alimenter le module communiquant à partir de la tension d'alimentation alternative Ua générée par le compteur 3 ;
- un dispositif de démodulation 10 qui est relié électriquement à la voie de signal V2 et qui est adapté à reproduire le signal numérique à partir du signal modulé alternatif reçu par le dispositif de démodulation 10 ;
- des moyens de contrôle 12, comportant un microcontrôleur 14 adapté, d'une part, à acquérir les informations TIC et éventuellement à les mettre en forme et, d'autre part, à commander certains composants du module communiquant 1 ;
- des moyens de communication 15, connectés aux moyens de contrôle 12, adaptés à communiquer par liaison radioélectrique avec le module passerelle 4, de manière à émettre et recevoir des données, notamment les informations TIC.

Les trois voies d'entrée V1, V2, V3 des moyens de connexion 8 sont donc reliées à l'interface TIC 2 du compteur 3, et permettent au module communiquant 1 de recevoir le signal de données et la tension d'alimentation Ua. Les moyens de connexion 8 sont eux-mêmes reliés au module d'alimentation 9 et au dispositif de démodulation 10.

L'unité de contrôle 12 est connectée :
- au module d'alimentation 9, duquel elle reçoit son alimentation,
- au dispositif de démodulation 10, qui lui transmet le signal numérique reproduit, et
- aux moyens de communication 15, auxquels elle transmet les informations TIC provenant du compteur 3 pour que les moyens de communication 15 les retransmettent au module passerelle 4.

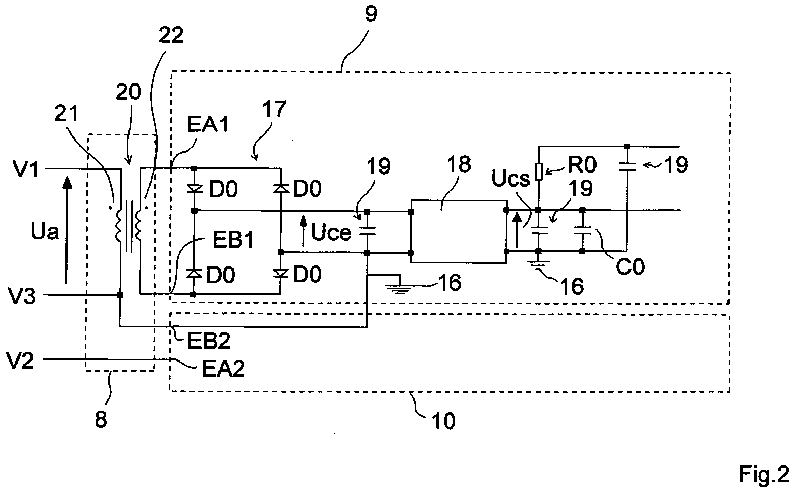

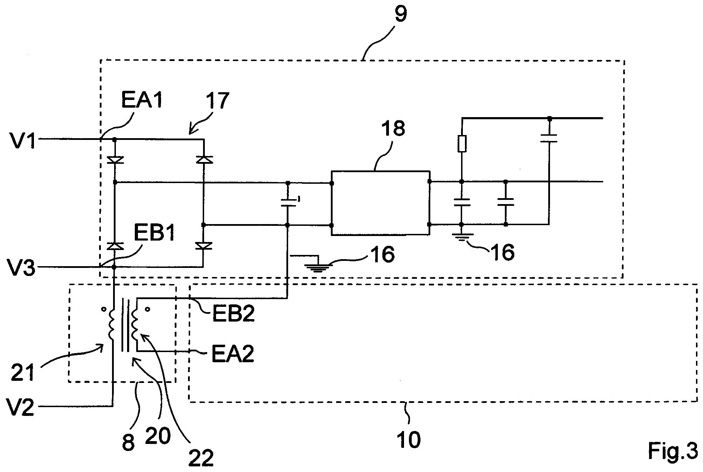

Le module d'alimentation 9, visible aux figures 2 et 3, comporte une entrée de potentiel haut EA1, une entrée de potentiel bas EB1, et est référencé à une masse électrique 16 du module communiquant 1. De même, le dispositif de démodulation 10 comporte une entrée de potentiel haut EA2, une entrée de potentiel bas EB2, et est référencé à la même masse électrique 16 du module communiquant 1.

Le module d'alimentation 9 comprend successivement :
- quatre diodes D0 de redressement formant un pont redresseur double alternance 17,
- un convertisseur de tension continue en tension continue 18,
- ainsi que divers composants électriques passifs d'alimentation 19 nécessaires au fonctionnement du convertisseur. Une cellule comportant des résistances R0 et un condensateur de stockage C0 est notamment ajoutée derrière le convertisseur pour alimenter l'amplificateur de puissance des moyens de communication 15. Le condensateur de stockage C0 permet de stocker et de libérer le pic de courant nécessaire à l'émission radioélectrique des informations TIC.

Le pont redresseur 17 permet de transformer la tension d'alimentation alternative Ua en une tension continue d'entrée Uce appliquée en entrée du convertisseur 18, qui lui-même transforme cette tension continue d'entrée Uce en une tension continue de sortie Ucs adaptée à alimenter les composants électriques du module communiquant 1. Alors qu'un pont redresseur simple alternance supprime les alternances négatives d'un signal alternatif, le pont redresseur double alternance redresse les alternances négatives de ce signal alternatif, ce qui augmente la puissance disponible à la sortie du pont. L'utilisation du pont redresseur double alternance 17 dans le module de communication 1 permet donc d'augmenter le courant disponible en sortie du convertisseur 18 sous la tension continue de sortie Ucs.

Il n'est cependant pas possible de connecter la sortie de masse S3 à la fois à l'entrée du pont redresseur 17 et à la masse électrique 16 du module communiquant 1, car la tension d'alimentation alternative Ua résulte d'une différence de potentiel entre la sortie d'alimentation S1 et la sortie de masse S3, et donc entre les voies V1 et V3 : les alternances négatives de la tension d'alimentation ne seraient pas redressées. Il est en outre nécessaire qu'à l'intérieur du module communiquant 1, la masse 16 utilisée comme référence pour le module d'alimentation et pour le dispositif de démodulation soit la même, pour éviter un conflit de masse.

Pour résoudre cette difficulté technique, on munit les moyens de connexion 8 d'un transformateur d'isolement 20, comportant un enroulement primaire 21 et un enroulement secondaire 22.

Dans un premier mode de réalisation des moyens de connexion 8, visible à la figure 2, on connecte le transformateur d'isolement 20 de sorte que l'enroulement primaire 21 soit connecté entre la voie d'alimentation V1 et la voie de masse V3, et de sorte que l'enroulement secondaire soit connecté entre les entrées EA1 et EB1 du module d'alimentation 9. On connecte de plus la voie de masse V3 à l'entrée bas potentiel EB2 du dispositif de démodulation 9, qui est elle-même connectée à la masse 16, et la voie de signal V2 à l'entrée haut potentiel EA2 du dispositif de démodulation 9.

Aucune des entrées du pont redresseur n'est donc reliée à la masse électrique 16 du module communiquant 1, ce qui autorise le redressement des alternances négatives. De plus, on forme une masse électrique unique 16 commune au compteur 3 et au module de communication 1, à laquelle sont référencés tous les éléments du module communiquant 1.

Dans un deuxième mode de réalisation des moyens de connexion 8, visible à la figure 3 on connecte le transformateur d'isolement de sorte que l'enroulement primaire 21 soit connecté entre la voie de signal V2 et la voie de masse V3, et de sorte que l'enroulement secondaire soit connecté entre les entrées EA2 et EB2 du dispositif de démodulation 10. On connecte de plus la voie d'alimentation V1 à l'entrée haut potentiel EA1 du module d'alimentation 9 et la voie de masse V3 à l'entrée bas potentiel EB1 du module d'alimentation 9.

Ainsi, on a constitué une masse électrique 16 du module communiquant 1 distincte de la masse électrique 7 du compteur 3. A nouveau, aucune des entrées du pont redresseur 17 n'est reliée à la masse électrique 16 du module communiquant 1, ce qui autorise le redressement des alternances négatives. On a en outre à nouveau une masse électrique unique 16 dans le module communiquant 1, à laquelle sont référencés tous les éléments du module communiquant 1.

Le premier mode de réalisation des moyens de connexion a pour désavantage, du fait de la présence du transformateur d'isolement 20 en entrée du module d'alimentation 9, de réduire le rendement de ces moyens. Le rendement est donc meilleur dans le deuxième mode de réalisation, mais la présence en entrée du dispositif de démodulation 10 du transformateur d'isolement 20 tend à déformer le signal modulé ce qui complique la démodulation.

On choisira donc le premier mode de réalisation lorsque la consommation du module communiquant 1 nécessite d'être optimisée relativement à la tension d'alimentation Ua et au courant délivré sous cette tension par le compteur électrique 3. On choisira le deuxième mode de réalisation lorsque la consommation du module communiquant 1 ne présente pas de difficulté particulière, et lorsque le signal de données est susceptible d'être particulièrement déformé, notamment lorsque le compteur électrique 3 lui-même comporte un transformateur d'isolement connecté entre la sortie de signal et la sortie de masse.

On comprend donc l'intérêt d'avoir un dispositif de démodulation qui soit le plus efficace possible. Ceci est d'autant plus vrai que, comme cela a été dit plus tôt, la transmission d'un état « zéro » ne correspond qu'à cinq périodes de la porteuse f0. En comparaison, avant l'évolution de la norme EN 62056-32, la fréquence de modulation utilisée était de 1200 bits par seconde : un état « zéro » correspondait alors à quarante périodes de porteuse. Cette norme impose au récepteur de traiter une dynamique en amplitude relativement importante. En outre, la présence de composants de protection (condensateurs, transformateur, etc.) du compteur 3 entraine des déformations du signal à traiter (régime pseudo-oscillant lors des transitoires). La réduction de la « durée » d'un état zéro rend un dispositif de démodulation plus sensible à une dynamique d'amplitude importante, car la durée totale de l'état est plus impactée, par exemple par un écroulement prématuré du signal, lorsque la durée de l'état est faible. On a donc cherché à mettre au point un dispositif de démodulation qui soit robuste et fiable à la fréquence de 9600 bits par seconde.

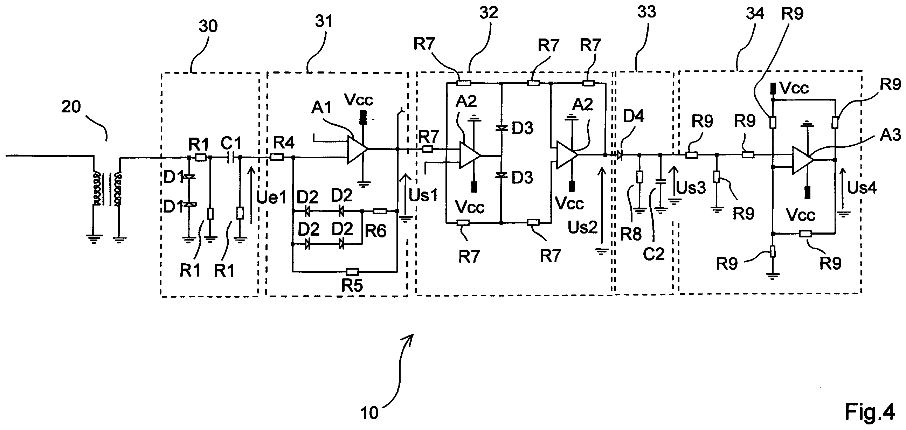

Dans un premier mode de réalisation du dispositif de démodulation 10, visible à la figure 4, celui-ci comporte :
- un étage d'entrée 30;
- un premier étage à gain variable 31, ici un étage à compression de grain ;
- un étage de redressement double alternance sans seuil 32 ;
- un étage de détection d'enveloppe 33 ;
- un comparateur à hystérésis 34.

On a ici mis en œuvre le dispositif de démodulation 10 avec des moyens de connexion 8 selon le deuxième mode de réalisation : le transformateur d'isolement 20 est connecté en entrée du dispositif de démodulation 10.

L'étage d'entrée 30 comporte des diodes Zener D1 destinées à protéger le reste du dispositif de démodulation contre d'éventuelles surtensions et des composants passifs R1, C1 destinés à fixer l'impédance du récepteur TIC en conformité avec la norme.

L'étage à compression de gain 31 comporte un amplificateur opérationnel A1 alimenté par une tension d'alimentation Vcc, quatre diodes D2 dites « diodes de sélection » et trois résistances de gain R4, R5, R6, dont deux R4, R5 ont la même valeur de résistance, ici 10 kilo-ohms, et la troisième R6 a une valeur plus faible, ici 100 ohms. Ainsi, si la tension du signal UE1 reçu en entrée de l'étage à compression de gain, ici le signal modulé alternatif, est faible, c'est-à-dire inférieure à un seuil prédéterminé dépendant des tensions de seuil des diodes D2, les diodes de sélection D2 sont bloquées, et l'amplitude du signal est multipliée par un gain G = - R5/R4, ici égal à - 1. Si la tension du signal est importante, les diodes de sélection D2 sont passantes et l'amplitude du signal est multiplié par un gain G = - (R5 // R6)/R4, ici proche de 0,01. L'étage à compression de gain 31 permet ainsi d'ajuster l'amplitude du signal reçu de manière à ce que les amplificateurs opérationnels A2 utilisés dans l'étage de redressement double alternance sans seuil 32 ne soient pas saturés par une amplitude de signal trop importante, et de manière à réduire la dynamique des distorsions temporelles dues aux effets du seuil du comparateur. On appelle « signal ajusté » US1 le signal en sortie de l'étage compresseur de gain 31.

Le signal ajusté US1 est ensuite appliqué en entrée de l'étage redresseur double alternance sans seuil 32, comportant deux amplificateurs opérationnels A2 alimentés par la tension d'alimentation Vcc, six résistances R7 ayant ici une valeur de résistance de 10 kilo-ohms, et deux diodes Schottky D3. L'étage redresseur double alternance 32 permet de redresser les alternances négatives du signal ajusté US1, tout en minimisant l'influence de tensions de seuil des diodes Schottky D3, lesdites tensions de seuil étant divisées par les gains des amplificateurs opérationnels A2. Comparativement à l'utilisation d'un système de redressement monoalternance, l'étage redresseur double alternance 32 présente l'avantage de réduire les distorsions temporelles introduites dans le système de remise en forme. L'étage redresseur double alternance 32 permet de générer en sortie un signal redressé US2.

Le signal redressé US2 est ensuite appliqué en entrée de l'étage de détection d'enveloppe 33. L'étage de détection d'enveloppe 33 comporte une diode Schottky D4 une résistance R8 et un condensateur C2. Les valeurs de résistance de R8 et de capacité de C2 sont choisies pour optimiser la détection de l'enveloppe, en fonction à la fois de la valeur de la fréquence porteuse f0 et de la valeur de la fréquence de modulation fM. L'étage de détection d'enveloppe 33 génère un signal d'enveloppe US3 qui, grâce à l'utilisation du redresseur double alternance, présente peu de variations de tension (ripple limité) et conserve une valeur sensiblement constante égale au maximum de l'amplitude du signal ajusté US1.

Enfin, le signal d'enveloppe US3 est appliqué en entrée du comparateur à hystérésis 34, comportant un amplificateur opérationnel A3 alimenté par la tension d'alimentation Vcc et sept résistances R9. On note la polarisation par la tension d'alimentation Vcc d'une entrée E+ de l'amplificateur opérationnel A3 et le rebouclage d'une sortie S de l'amplificateur opérationnel sur cette entrée E+, qui permettent de générer un seuil de comparaison variable assurant l'hystérésis.

Le signal obtenu US4 en sortie du comparateur à hystérésis 34 est donc une image très fidèle du signal numérique codant en ASCII les informations TIC transmises par le compteur électrique.

Dans un deuxième mode de réalisation du dispositif de démodulation, celui comporte :
- un étage d'entrée 30 semblable à celui décrit dans le premier mode de réalisation;
- un deuxième étage à gain variable 40, piloté par le microcontrôleur 14;
- un étage de mesure 41 ;
- un étage de redressement double alternance sans seuil 32 semblable à celui décrit dans le premier mode de réalisation ;
- un étage de détection d'enveloppe 33 semblable à celui décrit dans le premier mode de réalisation ;
- un comparateur à hystérésis 34 semblable à celui décrit dans le premier mode de réalisation.

On ne décrira ici que les étages qui ne sont pas semblables à ceux déjà décrits plus tôt.

Le deuxième étage à gain variable 40 comporte deux diodes Schottky D10, D11 dites « diodes de sélection », un amplificateur opérationnel A4, quatre condensateurs C10, quatre résistances R10, R11, R12, R13 de gain et quatre résistances de polarisation R14. Quatre sorties du microcontrôleur 14 sont reliées au deuxième étage à gain variable 40 via les résistances de polarisation R14.

L'étage de mesure 41 comporte une diode D15, un condensateur C15, une résistance R15. L'étage de mesure 41 est connecté en sortie du deuxième étage à gain variable 40, et est lui aussi relié au microcontrôleur 14, qui, grâce notamment à un convertisseur analogique-numérique non représenté (interne ou non au microcontrôleur 14), est adapté à acquérir la valeur de la tension Vmes en sortie du deuxième étage à gain variable 40. Selon la valeur de cette tension Vmes, et selon la nécessité d'amplifier ou au contraire d'atténuer le signal reçu, le microcontrôleur polarise les diodes de sélection D10, D11 en appliquant une tension de polarisation sur ses sorties connectées au deuxième étage à gain variable 40. Le microcontrôleur 14 rend ainsi ces diodes de sélection D10, D11 passantes ou bloquées selon l'amplification ou l'atténuation recherchée. On constate que le gain variable du deuxième étage à gain variable peut prendre les quatre valeurs suivantes : - R13 / R11 si aucune des diodes de sélection D10, D11 n'est passante, - R13 / (R11//R10) si la diode D10 est passante et la diode D11 est bloquée, et -R13 / (R11//R12) si la diode D11 est passante et la diode D10 est bloquée, et -R13 / (R10//R11//R12) si les deux diodes D10, D11 sont passantes. L'idée est ici de fixer le gain de la chaîne de réception en fonction du niveau reçu à l'entrée du récepteur. Ce gain est maintenu constant pendant toute la durée de l'acquisition du signal de TIC. Ce processus peut être mis en œuvre à chaque mise en service de l'acquisition TIC.

Grâce à ce deuxième étage à gain variable 40, il est possible de définir avec une grande précision la plage de variation d'amplitude du signal ajusté appliqué en entrée du redresseur, ce qui permet d'optimiser le fonctionnement du système complet.

L'invention n'est pas limitée aux modes de mise en œuvre particuliers qui viennent d'être décrits, mais, bien au contraire, couvre toute variante entrant dans le cadre de l'invention telle que définie par les revendications.

On a mis en œuvre l'invention sur un équipement électrique appelé « module communiquant », mais l'invention peut bien sûr être appliquée à tout équipement électrique adapté à être connecté à une interface de communication d'un compteur d'énergie électrique (délesteur, modem, etc.).

Bien que l'on ait cité un certain nombre de composants électriques du module communiquant, celui-ci peut bien sûr comporter des composants additionnels (module mémoire, etc.).

L'ensemble des valeurs numériques fournies pour définir des caractéristiques (capacité, résistance, etc.) de composants électrique est bien sûr fourni uniquement à titre illustratif.

On a défini deux modes de réalisation pour les moyens de connexion, et deux modes de réalisation pour le dispositif de démodulation. Chaque mode de réalisation des moyens de connexion peut parfaitement coopérer avec chaque mode de réalisation du dispositif de démodulation.

## Revendications

1. Dispositif de démodulation adapté à reproduire un signal numérique à partir d'un signal modulé alternatif reçu par le dispositif de démodulation, le signal modulé étant issu de la superposition du signal numérique et d'une porteuse, le dispositif de démodulation comportant :
- un étage à gain variable (31, 40) adapté à ajuster l'amplitude du signal modulé alternatif reçu en la multipliant par un gain pouvant prendre au moins deux valeurs différentes, de manière à délivrer un signal ajusté ;
- un étage redresseur double alternance sans seuil (32), comportant des diodes (D3), et adapté à redresser des alternances négatives du signal ajusté tout en minimisant l'influence de tensions de seuil des diodes (D3), de manière à fournir un signal redressé ;
- un étage de détection d'enveloppe (33) adapté à détecter une enveloppe du signal redressé, de manière à délivrer un signal d'enveloppe, l'étage de détection d'enveloppe comprenant une diode Schottky (D4), une résistance (R8) et un condensateur (C2) ;
- un comparateur à hystérésis (34) adapté à comparer le signal d'enveloppe avec un seuil de comparaison, de manière à restituer le signal numérique.

2. Dispositif de démodulation selon la revendication 1, dans lequel l'étage à gain variable (31, 40) est un étage à compression de gain destiné à réduire l'amplitude du signal modulé alternatif reçu.

3. Dispositif de démodulation selon l'une des revendications précédentes, dans lequel la valeur du gain de l'étage à gain variable (31, 40) dépend de l'état passant ou ouvert d'au moins une diode de sélection (D2, D10, D11).

4. Dispositif de démodulation selon la revendication 3, dans lequel la diode de sélection (D2) est dans un état bloqué lorsque le signal modulé alternatif reçu a une amplitude inférieure à un seuil prédéterminé et dans un état passant lorsque le signal modulé alternatif reçu a une amplitude supérieure ou égale au seuil prédéterminé.

5. Dispositif de démodulation selon la revendication 3, dans lequel l'état de la diode de sélection est commandé sélectivement par application d'une tension de commande aux bornes de la diode de sélection (D10, D11).

6. Dispositif de démodulation selon la revendication 5, dans lequel l'état de la diode de sélection est commandé en fonction d'un signal mesuré en sortie de l'étage à gain variable (40).

7. Dispositif de démodulation selon l'une des revendications précédentes, dans lequel l'étage à gain variable (31, 40) est adapté à ajuster l'amplitude du signal modulé alternatif de manière à ce que des amplificateurs opérationnels (A2) de l'étage redresseur double alternance sans seuil (32) ne soient pas saturés par l'amplitude du signal modulé alternatif.

8. Equipement électrique destiné à être connecté à un compteur d'énergie électrique (3) et adapté à lire un signal numérique émis par le compteur (3), l'équipement électrique comportant un dispositif de démodulation (9) selon l'une des revendications précédentes permettant à l'équipement électrique de reproduire le signal numérique.

## Patentansprüche

1. Demodulationsvorrichtung, die geeignet ist, aus einem von der Demodulationsvorrichtung empfangenen modulierten Wechselsignal ein digitales Signal wiederzugeben, wobei das modulierte Signal aus der Überlagerung des digitalen Signals und eines Trägers stammt, wobei die Demodulationsvorrichtung umfasst:
- eine Stufe (31, 40) mit veränderlicher Verstärkung, die geeignet ist, die Amplitude des empfangenen modulierten Wechselsignals anzupassen, indem sie mit einer Verstärkung multipliziert wird, die mindestens zwei unterschiedliche Werte annehmen kann, derart, dass ein angepasstes Signal geliefert wird;
- eine Doppelwechsel-Gleichrichterstufe (32) ohne Schwellenwert, die Dioden (D3) umfasst und geeignet ist, negative Wechsel des angepassten Signals gleichzurichten, während der Einfluss von Schwellenspannungen der Dioden (D3) minimiert wird, derart, dass ein gleichgerichtetes Signal geliefert wird;
- eine Hüllkurvendetektionsstufe (33), die geeignet ist, eine Hüllkurve des gleichgerichteten Signals zu detektieren, derart, dass ein Hüllkurvensignal geliefert wird, wobei die Hüllkurvendetektionsstufe eine Schottky-Diode (D4), einen Widerstand (R8) und einen Kondensator (C2) umfasst;
- einen Komparator (34) mit Hysterese, der geeignet ist, das Hüllkurvensignal mit einem Vergleichsschwellenwert zu vergleichen, derart, dass das digitale Signal wiederhergestellt wird.

2. Demodulationsvorrichtung nach Anspruch 1, bei der die Stufe (31, 40) mit veränderlicher Verstärkung eine Stufe mit Verstärkungskompression ist, die dazu bestimmt ist, die Amplitude des empfangenen modulierten Wechselsignals zu verringern.

3. Demodulationsvorrichtung nach einem der vorhergehenden Ansprüche, bei der der Wert der Verstärkung der Stufe (31, 40) mit veränderlicher Verstärkung von dem Durchgangszustand oder offenen Zustand mindestens einer Auswahldiode (D2, D10, D11) abhängt.

4. Demodulationsvorrichtung nach Anspruch 3, bei der die Auswahldiode (D2) in einem blockierten Zustand ist, wenn das empfangene modulierte Wechselsignal eine Amplitude unter einem vorbestimmten Schwellenwert hat, und in einem Durchgangszustand ist, wenn das empfangene modulierte Wechselsignal eine Amplitude über oder gleich dem vorbestimmen Schwellenwert hat.

5. Demodulationsvorrichtung nach Anspruch 3, bei der der Zustand der Auswahldiode durch Anlegen einer Steuerspannung an die Klemmen der Auswahldiode (D10, D11) selektiv gesteuert wird.

6. Demodulationsvorrichtung nach Anspruch 5, bei der der Zustand der Auswahldiode in Abhängigkeit von einem am Ausgang der Stufe (40) mit veränderlicher Verstärkung gemessenen Signal gesteuert wird.

7. Demodulationsvorrichtung nach einem der vorhergehenden Ansprüche, bei der die Stufe (31, 40) mit veränderlicher Verstärkung geeignet ist, die Amplitude des modulierten Wechselsignals derart anzupassen, dass Operationsverstärker (A2) der Doppelwechsel-Gleichrichterstufe (32) ohne Schwellenwert nicht durch die Amplitude des modulierten Wechselsignals gesättigt werden.

8. Elektrische Ausrüstung, die dazu bestimmt ist, mit einem Stromzähler (3) verbunden zu werden und geeignet ist, ein von dem Zähler (3) gesendetes digitales Signal zu lesen, wobei die elektrische Ausrüstung eine Demodulationsvorrichtung (9) nach einem der vorhergehenden Ansprüche umfasst, die der elektrischen Ausrüstung ermöglicht, das digitale Signal wiederzugeben.

## Claims

1. Demodulation device adapted to reproduce a digital signal from an alternating modulated signal received by the demodulation device, the modulated signal resulting from the superposition of the digital signal and of a carrier, the demodulation device comprising:
- a variable gain stage (31, 40) adapted to adjust the amplitude of the received alternating modulated signal by multiplying it by a gain that can take at least two different values, so as to deliver an adjusted signal;
- a full-wave rectifier stage (32) with no threshold comprising diodes (D3) and adapted to rectify negative half-waves of the adjusted signal while minimizing the influence of threshold voltages of the diodes (D3) so as to provide a rectified signal;
- an envelope detection stage (33) adapted to detect an envelope of the rectified signal so as to deliver an envelope signal, the envelope detection stage comprising a Schottky diode (D4), a resistor (R8) and a capacitor (C2);
- a hysteresis comparator (34) adapted to compare the envelope signal with a comparison threshold so as to restore the digital signal.

2. Demodulation device according to claim 1, wherein the variable gain stage (31, 40) is a gain compression stage intended to reduce the amplitude of the received alternating modulated signal.

3. Demodulation device according to either one of the preceding claims, wherein the value of the gain of the variable gain stage (31, 40) depends on the on or off state of at least one selection diode (D2, D10, D11).

4. Demodulation device according to claim 3, wherein the selection diode (D2) is in an off state when the received alternating modulated signal has an amplitude below a predetermined threshold and in an on state when the received alternating modulated signal has an amplitude greater than or equal to the predetermined threshold.

5. Demodulation device according to claim 3, wherein the state of the selection diode is selectively controlled by application of a control voltage to the terminals of the selection diode (D10, D11).

6. Demodulation device according to claim 5, wherein the state of the selection diode is controlled as a function of a signal measured at the output of the variable gain stage (40).

7. Demodulation device according to any one of the preceding claims, wherein the variable gain stage (31, 40) is adapted to adjust the amplitude of the alternating modulated signal so that operational amplifiers (A2) of the full-wave rectifier stage (32) with no threshold are not saturated by the amplitude of the alternating modulated signal.

8. Electrical equipment intended to be connected to an electrical energy meter (3) and adapted to read a digital signal emitted by the meter (3), the electrical equipment including a demodulation device (9) according to any one of the preceding claims enabling the electrical equipment to reproduce the digital signal.
